# EUROPEAN PATENT APPLICATION

(11) **EP 4 576 204 A1**
(43) Date of publication of application: **25.06.2025**
(21) Application number: 23219774.9
(22) Date of filing: 22.12.2023
(51) Int. Cl.: H01L 23/492, H01L 23/00, H01L 23/36, H01L 23/495

(54) **POWER STAGE DEVICE CLIP**

(71) Applicant: Nexperia B.V., 6534 AB Nijmegen (NL)
(72) Inventor: Milo, Dolores, Manchester (GB); Yandoc, Ricardo, Manchester, SK7 5BJ (GB); Qu, Yong, Manchester, SK7 5BJ (GB)
(74) Representative: Pjanovic, Ilija

(57) **Abstract**

The present disclosure relates to a clip for use with a power stage device. The clip comprises a first portion defining a first planar surface and a second portion connected to the first portion. The second portion comprises a second planar surface, a cavity defined in the second planar surface, and at least one notch in a perimeter of the second planar surface, wherein the at least one notch extends into the cavity. Further described are a power driver device comprising the clip of present disclosure, methods of forming the clip, and methods of forming a power driver device.

## Description

### FIELD

The present invention relates to a clips for power stage devices, and methods of forming said clips.

### BACKGROUND

Power stage devices, such as DrMOS and eFuse devices may require both a driver component in the form of IC die, and at least one component (such as a MOSFET) connected to the driver. If a large die component is being used in the power stage device, the die and MOSFET components may have a substantial footprint on the board which they are arranged, resulting in a larger overall integrated circuit package being produced. This may be undesirable if the electrical device in which the integrated circuit package is to be incorporated has limited space to accommodate its electrical circuitry.

Further, maintaining the integrity of the components in the electrical circuitry of a device is also a key factor in optimising the lifespan of electrical devices. If, over time, components such as the die or MOSFET of an integrated circuit package are subject to wear or become damaged, the electrical device may malfunction (or cease working entirely), requiring repair of replacement of the device.

The present invention seeks to obviate, or at least mitigate, the problems associated with known apparatus, whether identified herein or otherwise.

### SUMMARY

In a first aspect of the invention there is provided a clip for use with a power stage device. The clip comprises a first portion defining a first planar surface, and a second portion connected to the first portion. The second portion comprises a second planar surface, a cavity defined in the second planar surface, and at least one notch in a perimeter of the second planar surface, wherein the at least one notch extends into the cavity.

The first and second portions may define a frame for arranging components of an electrical circuit or integrated circuit package, such as a package for a Driver-MOSFET (DrMOS) or an electronic fuse (eFuse); which may require multiple semi-conductors in their assembly. Further, such components may be disposed in or arranged relative to surface features of the first and second portions. For example, a semi-conductor may be disposed in the cavity of the second portion of the clip. The cavity may help to hold the die in place on the clip during manufacture, preventing movement of the die from its intended position; ultimately improving the quality and consistency of the final IC packages/power stage devices. The cavity may also help to contain solder (or any other conductive adhesives that may be used, such as conductive epoxy, acrylic or silicone based adhesives) when attaching the die to the clip, again helping to improve the quality of the final IC packages incorporating the clip.

A clip formed in this manner may also help to minimise the circuit board space that is occupied by the final IC package/power stage device in which the clip in incorporated. For example, the clip may allow for a die and a MOSFET to be `stacked' on top of one and other, while also being in electrical communication. During assembly of the power stage device, the second portion may be arranged on top of a MOSFET, with an underside of the cavity in contact with the MOSFET. A die may then be disposed and attached in the cavity, resulting in vertical 'stacking' of the MOSFET and the die, reducing the footprint required by these components.

Providing notches in the perimeter of the second portion, wherein the notches extend into the cavity, may also provide a number of advantages when power stage drivers are assembled with vertically 'stacked' components. For example, sharp or pointed vertices (which may be provided on traditional power stage drive clips) can provide areas of high stress concentration on the underlying MOSFET, both during manufacture and use of the power stage driver. Therefore, over time, such points of high stress concentration may damage the MOSFET, ultimately leading to the MOSFET to malfunction, or stop working entirely. Therefore, the notches of the second portion of the clip mitigate against such points of high stress concentration, helping to prolong the life of the MOSFET and improve the reliability of the power stage driver, and any devices it may be incorporated in.

Further, the notches in the perimeter of the second portion may also allow for larger die to be placed in the cavity than could be used with traditional power stage driver clips of the same size, as portions of the die may be able to overhang the edges of the cavity in which the die is disposed.

At least one of the first and second portions may be formed of or comprise a wettable material. At least one of the first and second portions may be formed of or comprise metallic wettable material. If the clip is formed or comprises a wettable material, this may allow for the die to be soldered directly to the clip. Further, as the die may be disposed in the cavity, the cavity acts to contain the solder used in attaching the die to the clip, ultimately aiding manufacture quality of the power stage device. Further, if the power stage device is assembled using the vertical `stacking' method as outlined above, the second portion of the clip may be soldered directly to a top contact area of a MOSFET (e.g. via the underside of cavity of the second portion).

By forming the clip of a metallic wettable material, electrical communication may be permitted between a MOSFET and a die of a power stage device via the clip. The clip may be formed of any suitable metallic wettable material within the understanding of one skilled in the art, such as tin, copper, nickel, aluminium, alloys thereof, etc.

The cavity may define a third planar surface. The third planar surface of the cavity may be configured to seat a die. As outlined above, the combination of the third planar surface and the cavity may help to seat and align the die during manufacture, while also holding the die in place during subsequent manufacturing steps, ultimately improving manufacture and product quality of the power stage driver.

The cavity defined in the second planar surface may be square. Alternatively, the cavity defined in the second planar surface may be rectangular.

The at least one notch may comprise one of, a curved notch, a triangular notch and a right-angled notch.

According to a second aspect of the invention, there is provided a power stage device. The power stage device comprises;
a MOSFET,
a clip comprising a first portion defining a first planar surface, and a second portion connected to the first portion; wherein the second portion comprises a second planar surface, a cavity defined in the second planar surface, and at least one notch in a perimeter of the second planar surface, wherein the at least one notch extends into the cavity,
wherein the cavity is disposed on the MOSFET, such that the cavity is in electrical communication with the MOSFET; and,
a die disposed within the cavity of the clip.

According to a third aspect of the present invention, there is provided a method of forming a clip for use with a power stage device. The method comprises; providing a frame comprising a first planar portion and a second planar portion connected to the first planar portion, stamping a cavity into the second planar portion, and cutting at least one notch into a perimeter of the second portion, wherein the at least one notch extends into the cavity.

This method provides a simple and cost effective method for producing clips to be used with power stage drivers, or the like, while also providing clips with the additional advantages outlined above. By using simple manufacturing processes such as stamping (to form the cavity in the second portion of the clip), high quality clips can be manufactured quickly and with reduced costs.

The method may comprise stamping one of a square cavity and a rectangular cavity into the second planar portion

The method may comprise forming at least one of a curved notch, a triangular notch, and a right-angled notch, into the perimeter of the second portion.

The frame may be a metallic frame. The frame may be a wettable metallic frame.

According to a fourth aspect of the present invention, there is provided a method of forming a power driver device. The method comprises forming a clip by providing a frame comprising a first planar portion and a second planar portion connected to the first planar portion, stamping a cavity into the second planar portion, and forming at least one notch into a perimeter of the second portion, wherein the at least one notch extends into the cavity; disposing the cavity of the clip on a MOSFET, such that the cavity is in electrical communication with the MOSFET; and, attaching a die within the cavity of the clip.

It will be appreciated that the advantages discussed above in relation to the first aspect of the invention apply mutatis mutandis to this aspect of the invention.

### BRIEF DESCRIPTION OF THE DRAWINGS

Embodiments of the present invention will now be described with reference to the accompanying drawings, in which:
Figures 1A and 1B show perspective views of a clip for power stage devices;
Figures 2A and 2B show a plan view and a side view respectively of power stage device comprising the clip of Figures 1A and 1B; and,
Figures 3A and 3B show a perspective view and a plan view of a power stage device assembled on a lead frame.

### DETAILED DESCRIPTION

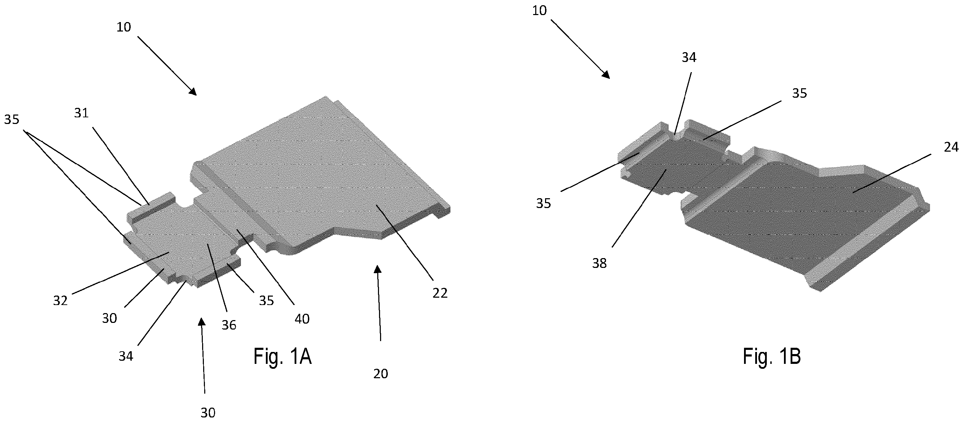

Figures 1A and 1B show perspective views of clip 10 for power stage devices according to the present disclosure.

First shown within Figure 1A, the clip 10 comprises a first portion 20 and a second portion 30, connected by a connecting portion 40. The first portion 20 defines a first planar surface 22 on its upper side. As shown in this example, a planar surface may also be defined on the underside 24 of the first portion 20. The first planar surface 22 may provide a surface for components of a power stage to be disposed on/attached to during assembly, or an attachment surface for connecting a power stage device to other components of an electrical circuit. In other examples, one or more surface features may extend from, or be defined in, the first planar surface 22. The planar surface defined on the underside 24 of the first portion 20 also provides a surface for components of a power stage device to be disposed on/attached to, or provides an attachment surface for connecting the power stage device to other components of an electrical circuit. Further, one or more surface features may extend from, or be defined in, the planar surface of the underside 24 of the first portion 20.

Connected to the first portion 20 by the connecting member 40 is the second portion 30. The second portion defines a second planar surface 31 on its upper side. A cavity 32 is defined within the second planar surface 31. During manufacture, the clip may initially be provided with the first and second portions 20, 30 that are substantially flat, or which comprise substantially flat areas. During subsequent manufacture steps, surface features, such as the cavity 32 of the second portion 30 of the clip 10, may be formed by stamping or machining (for example) the clip 10. In this example, the cavity 32 formed in the second portion 30 of the clip 10 also defines a third planar surface 36. Therefore, the cavity 32 may be used to seat a component of the final power stage device, which will be explained below in greater detail. In this example, the cavity 32 is configured to seat an integrated circuit die. In other examples, the cavity 32 may be used to house or seat other components of the power stage device in which the clip 10 is incorporated.

The second portion 30 further comprises an outer perimeter 35. In this example, the outer perimeter 35 defines a substantially rectangular shape, but in other examples the perimeter 35 may define a different shape (e.g. a substantially square, circular or triangular shape, for example). A plurality of notches 34 are defined in the perimeter 35 of the second portion 30. In this example, four notches 34 are provides, with the notches 34 disposed at corners of the second portion 30. In this example, the notches 34 are curved, but other examples may comprise notches 34 of different shapes/configurations, dependent upon the application.

Within Figures 1A and 1B, the notches 34 also extend into the cavity 32, the advantages of which will be outlined below in greater detail. The extension of the notches 34 into the cavity 32 may be varied dependent on the technical requirements of various components of the power stage device in which the clip 10 is incorporated.

As best shown in Figure 1B, the cavity 32 of the clip 10 defines a lower or bottom surface 38. As this example comprises a cavity 32 which has been stamped into the second portion 30 of the clip 10, the lower or bottom surface 38 of the cavity 32 extrudes from an underside of the second portion 30. This may be beneficial during assembly of the power stage clip, as the bottom surface 38 of the cavity can engage, and be used as an attachment surface, for additional components of the power stage clip, such as a MOSFET (with the bottom side 38 of the cavity engaging and connecting with a contact surface of a MOSFET, explained below in greater detail).

The clip 10 of Figures 1A and 1B may be formed of any suitable material within the understanding one skilled in the art. For example, the clip 10 may be formed of a wettable material. Forming the clip 10 of a wettable material may allow for attachment of components (e.g. via soldering), such as integrated circuit chips or the like, to the clip 10. Further, if the clip 10 is formed of a wettable material, this may allow for surfaces of the clip 10 (such as the lower surface 38 of the cavity 32, or the upper and lower surfaces 22, 24) to be attached to other components (e.g. via soldering), such as other components of an electrical circuit or an integrated circuit package.

The wettable material used to form the clip 10 may be a metallic wettable material. Examples of metallic wettable materials that may be used are tin, nickel, copper, aluminium, alloys including these wettable metals, etc.

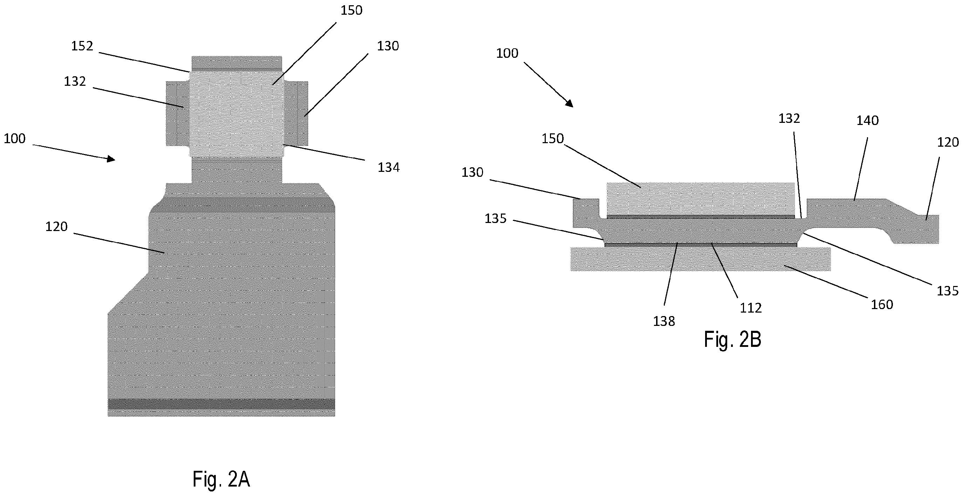

Figures 2A and 2B show an example of the clip 100 of Figures 1A and 1B assembled with a die 150 and a MOSFET 160 (e.g. the basic structure of a power stage device). Like components of Figures 1A, 1B and 2A, 2B use the same reference numerals, incremented by 100.

The die 150 is assembled within the cavity 132 of the clip 100. As described above, if the clip 100 is formed of a wettable material, the die 150 may be soldered in the cavity 132 of the clip 100. In other examples, the die 150 may be attached to the clip 100 via any alternative means within the understanding of the skilled person.

As shown in Figure 2A, the cavity 132 formed in the second portion 130 is square shaped, matching the shape of the die 150 seated within the cavity 132. Therefore, during manufacture, the shape of the cavity 132 may be matched to component to be seated in the cavity 132. This may help to align the die 150 on the clip 100 during assembly/manufacture, and may hold the die 150 in place during subsequent steps manufacture (e.g. preventing the die from rotating in the cavity). In other examples, during manufacture, the cavity 132 may be shaped differently (e.g. rectangular shaped) to match a different component to be housed in the cavity 132.

The cavity may also help to contain excess solder (or any other conductive adhesives that may be used, such as conductive epoxy, acrylic or silicone based adhesives) when attaching the die 150 in the cavity 132. This may further help to improve manufacture/product quality, as excess solder/adhesive is prevented from spreading to other areas of the clip (which otherwise may have to be removed, decreasing the efficiency of the manufacture process).

As also shown Figure 2A, the die 150 extends into the notches 134 of the clip 100. In this example, the notches 134 have been formed in the corners of the second portion 130, to align with the corners 152 of the die 150 that is disposed in the cavity 132. Specifically aligning the notches 134 and the corners 152 of the die 150 disposed in the cavity 132 in this manner allows a larger die 150 to be used than would normally be used in the same size of clip 100 (but which did not have notches aligned with the corners of the die 150). As the die 150 must be protected from damage or wear during manufacture, if a die is disposed in a cavity, it is generally desirable to leave sufficient room between the walls of the cavity and the die, to provide room for movement of the die during manufacture, mitigating against collisions between the die and the surrounding walls. Collisions between the corners of the die and the walls of the cavity can be particularly damaging to the die during manufacture - ultimately impacting product quality. By disposing the notches 134 in line with the corners of the die 150 in the cavity 132, a larger die may be used with a clip 100 of this design, as collisions between the corners 152 of the die 150 and the walls of the cavity are not of concern. This may allow for more powerful power stage devices to be manufactured without the need for the devices to occupy a larger footprint (as a larger IC driver can be used).

As shown best in Figure 1A, the notches 134 of this example are formed with rounded edges. The geometry of the notches may vary dependent on the requirements of the clip 100 though. For example, the notches may be substantially triangular, square, etc. The skilled person will understand that the notches 134 may be any suitable geometry that will produce the advantages associated with these features, described herein.

The notches 134 may be formed in the second portion 134 by any suitable means within the understanding of the skilled person. For example, the notches 134 may be formed by one of punching, cutting, machining, electric discharge machining and laser cutting, etc. or combinations thereof.

The notches 134 may be formed in the second portion 130 at any suitable stage of manufacture of the clip 100. For example, the notches 134 may be formed in the second portion 130 prior to the cavity 132 being formed in the second portion 130. Alternatively, the notches 134 may be formed after the cavity 132 has been formed in second portion 130.

Within Figure 2B, the lower surface 138 of the clip 100 has been connected to a second component 160 of the power stage device. In this example, the lower surface 138 of the cavity 132 of the second portion 130 has been connected to a contact surface (not shown) of a MOSFET 160 via soldering 112 (although other means of attachment may be used in other embodiments of the invention, as described above). As the second portion 130 comprises a cavity 132 and a lower surface 138 of the cavity 132 which extends from the second portion 130, this allows for vertical 'stacking' of the of the components of the power stage device. As shown in Figure 2B, the 'stacking' is achieved by aligning the lower surface 138 of the cavity 132 with a contact surface of a MOSFET 160, and disposing a die 150 in the cavity 132. This allows for the MOSFET 160 and die 150 to be in electrical communication with one and other, while also minimising the footprint of the final power stage device (as traditionally a die and its associated MOSFET may be arranged side-by-side on a circuit board, lead frame or clip).

As described above, the notches 134 of the second portion 130 may extend into the cavity 132 of the second portion. In the example of Figures 1A to 3B, the notches extend into the cavity 132 such that the corners of the cavity have been removed. During assembly or use of the power stage device, corners of a cavity may produce areas of concentrated stress on the MOSFET to which the cavity is connected (via its lower surface). Over time, these concentrated areas of stress may damage the MOSFET, leading to the power stage clip functioning incorrectly. By including notches 134 which extend into the cavity 132 of the clip 100 of the present invention, with the notches 134 being disposed at and extended into the corners of the cavity 132, such concentrated areas of stress on the MOSFET 160 are mitigated against, helping to prolong the life of the MOSFET 160, and ultimately the power stage clip.

The notches 134 may extend into the cavity 132 as far is required by the clip 100 and MOSFET 160 connected to the lower side 138 of the cavity 132.

As outlined above, as the cavity 132 of this example has been stamped into the second portion 130 of the clip 100, the cavity 132 extends from the second portion 130. As well as creating a lower surface 138 of the cavity 132, this also defines a plurality of attachment surfaces 135 for use when connecting the cavity 132 to the MOSFET 160. During assembly, solder can be applied to attachment surfaces 135 as well the lower surface 138 of the cavity to provide a robust and reliable connection between the clip 100 and the MOSFET 160. The attachment surfaces 135 also serve to contain the any solder that may be used in the attachment of the MOSFET 160 to the clip 100, ultimately helping to improve manufacture efficiency and quality of the power stage device in which the clip 100 of the present invention is used.

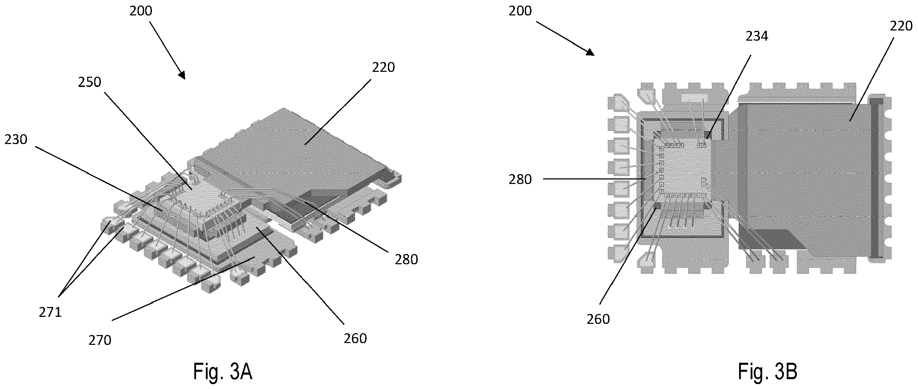

Figures 3A and 3B show the clip 200 of Figures 1A to 2B assembled to a lead frame 270, prior to encapsulation to create the final integrated circuit package.

Within Figure 3A, the MOSFET 260 has been connected to a lead frame 270. The die 250 has then been wire bonded to contact pads 271 of the lead frame 270 via bond wires 280. The first portion 220 of the clip 200 has also been connected to the lead frame 270. Following connection of the clip 200 to the lead frame 270, and wire bonding of the die 250 to the contact pads 271 of the lead frame 270, the assembly may be encapsulated in a protective encapsulant to form an integrated circuit package.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A clip for use with a power stage device, the clip comprising;
a first portion defining a first planar surface, and
a second portion connected to the first portion, the second portion comprising;
a second planar surface;
a cavity defined in the second planar surface; and,
at least one notch in a perimeter of the second planar surface, wherein the at least one notch extends into the cavity.

2. The clip of claim 1, wherein at least one of the first and second portions are formed of a wettable material.

3. The clip of claim 2, wherein at least one of the first and second portions comprise metallic wettable material.

4. The clip of any one of claims 1 to 3, wherein the cavity defines a third planar surface.

5. The clip of claim 4, wherein the third planar surface of the cavity is configured to seat a die.

6. The clip of any preceding claim, wherein the cavity defined in the second planar surface is a square.

7. The clip of any one of claims 1 to 5, wherein the cavity defined in the second planar surface is a rectangular.

8. The clip of any preceding claim, wherein the at least one notch comprises;
a curved notch;
a triangular notch; and,
a right-angled notch.

9. A power driver device comprising;
a MOSFET
the clip of any preceding claim, wherein the cavity is disposed on the MOSFET, such that the cavity is in electrical communication with the MOSFET; and,
a die disposed within the cavity of the clip.

10. A method of forming a clip for use with a power stage device, comprising providing a frame comprising;
a first planar portion; and,
a second planar portion connected to the first planar portion;
stamping a cavity into the second planar portion; and,
providing at least one notch into a perimeter of the second portion, wherein the at least one notch extends into the cavity.

11. The method of claim 10, comprising stamping one of a square cavity into the second planar portion

12. The method of claims 10 or 11, comprising providing at least one of;
A curved notch;
A triangular notch; and
A right-angled notch, into the perimeter of the second portion.

13. The method of any one of claims 10 to 12, wherein the frame is a metallic frame.

14. The method of any one of claims 10 to 13, wherein the frame is a wettable metallic frame.

15. A method of forming a power driver device comprising;
forming a clip according to any one of claims 10 to 14,
disposing the cavity of the clip on a MOSFET, such that the cavity is in electrical communication with the MOSFET; and
attaching a die within the cavity of the clip.
